# EUROPEAN PATENT APPLICATION

(11) **EP 4 625 474 A1**
(43) Date of publication of application: **01.10.2025**
(21) Application number: 24209915.8
(22) Date of filing: 30.10.2024
(51) Int. Cl.: H01L 21/306

(54) **METHOD AND APPARATUS FOR PLASMA ETCHING A SUBSTRATE**

(30) Priority: 27.03.2024 GB 202404374
(71) Applicant: SPTS Technologies Limited, NP18 2TA (GB)
(72) Inventor: BURNETT, Jay Leslie, Newport (GB); ASHRAF, Huma, Newport (GB)
(74) Representative: Wynne-Jones IP Limited

(57) **Abstract**

According to the invention there is provided a method of plasma etching a substrate comprising at least one GaN or GaN alloy layer to form a feature, the method comprising the steps of:
(a) providing a substrate with a mask formed thereon, the mask having an opening, wherein the substrate comprises at least one GaN or GaN layer;
(b) performing a first plasma etch step to anisotropically etch the at least one GaN or GaN alloy layer through the opening to produce a partially formed feature having one or more side walls and a bottom surface comprising a peripheral region, wherein the first plasma etch step uses an etch recipe comprising a chlorine-based etchant; and
(c) performing a second plasma etch step to anisotropically etch the bottom surface of the partially formed feature through the opening while depositing a passivation material onto the walls, wherein the second plasma etch step uses an etch recipe comprising a chlorine-based etchant and a fluorocarbon-based passivation material precursor and wherein the deposition of the passivation material within the feature causes an attenuation in etching of the peripheral region thereby producing a fully formed feature having a bottom surface comprising a central region and an edge region, wherein the edge region is curved and the central region is deeper than the edge region of the bottom surface of the fully formed feature.

## Description

### Field of the Disclosure

This invention relates to a method of plasma etching a substrate, with particular reference to etching a substrate comprising at least one GaN or GaN alloy layer to form a feature. The invention relates also to an associated apparatus for plasma etching a substrate, and to a substrate comprising at least one GaN or GaN alloy layer having a feature formed therein.

### Background of the Disclosure

Gallium nitride (GaN) is increasingly used as a wide-band gap, high charge mobility and relatively low dielectric constant material for power semiconductor devices, particularly as a gate trench in MOSFET devices. Such properties can be exploited in a wide range of devices and applications. For example, transistors with fast switching speeds and low losses can be provided, as well as power converters with high power densities. Other areas of applications include: technologies for fast charging electric vehicles through compact OBCs (onboard chargers) and HV DC-DC with twice the power density of alternative materials; high efficiency and diverse LED applications; always-on energy intensive data centres with improved efficiencies; high power density converters for photovoltaic harvesting and storage; and consumer electronics with greater power densities such as next generation chargers, PC DC-DC converters, and others. Dry etched gallium nitride trenches with a typical width of 1-5µm and a typical depth of 1-3µm are well suited to such uses.

In a typical GaN power device, such as a MOSFET device, the gate trench acts to control the width of the depletion region, and therefore controls the conductivity of the channel between the source and drain. The exact shape of the gate etch itself is important for numerous reasons relating to device operation (penetrating deep enough into drift region, sufficient sidewall profile angle for good dielectric deposition coverage etc.) and, importantly for the purposes of this application, the minimisation of charge leakage. Such leakage occurs as a result of a build up of charge, often at the etched trench corners, giving rise to a large electric field gradient across the channel-dielectric-metal interface. When the resulting potential difference is greater than the metal-insulator-semiconductor Schottky barrier height of the interface, charge leakage occurs. This causes a reduction in breakdown voltage, which limits the maximum rectifying power of the device. First generation GaN devices with a breakdown voltage of about 100V are already established and commercially available, whilst 600/650V platforms are currently of industrial interest. However, global demand for devices exceeding 1200V is increasing. Such devices, often of a vertical architecture, experience additional charge losses, making the minimisation of charge leakage ever more significant. Hence, trench formation and, importantly, corner rounding is predicted to play an ever-important role in the realisation of high-breakdown-voltage GaN transistors.

Currently, industry is focused on reducing charge leakage via the reduction of micro-trenching at the trench corners, where ion deflections, nuances of etch mechanism, species transport and consumption at etch front along with ion energy and wafer-level current density considerations cause an elevated etch rate at the trench corners relative to the trench centre, inducing triangular shaped points. Such points act as a source of significant charge build-up and charge leakage. Despite it being possible to successfully fabricate flat based trenches, the breakdown voltage is still restricted by the discontinuous nature of flat trench corners. Consequently, there is growing demand from industry and literature for dry etch solutions that produce rounded corners in GaN trenches.

Corner rounding during dry etching of GaN with a photoresist (PR) mask is not trivial owing to the tendency of GaN to form highly anisotropic etch profiles with sharp corners for most process windows. Currently, corner rounding is possible via wet etch processes, for example, with the use of tetramethylammonium hydroxide. Whilst able to achieve rounded base control at significantly lower processing temperatures (<100°C) than the equivalent wet processes used to round Si and SiC trenches (>1000°C during anneal), the additional processing step has significant drawbacks. These drawbacks include: the significant process time (more than 70mins), the use of non-environmentally friendly chemicals, difficulties in incorporating the wet etch step into existing process flows, inherent difficulties in controlling etch profiles with preferential etching of crystal planes, and non-trivial end-pointing. All of this makes the provision of a workable alternative solution highly attractive.

### Statement of Invention

The present invention, in at least some of its embodiments, addresses the above-described problems, desires and requirements. In particular, the present invention, in at least some of its embodiments, proposes an industry scalable dry plasma etch solution for GaN, which allows corner rounding to be achieved in situ during dry etching of the trench or other feature. As a result, no additional non-plasma etch steps are necessary and there is no significant disruption to process flow. The invention is also applicable to the etching of GaN alloys such as AlGaN and In GaN.

According to a first aspect of the invention there is provided a method of plasma etching a substrate comprising at least one GaN or GaN alloy layer to form a feature, the method comprising the steps of:
a. providing a substrate with a mask formed thereon, the mask having an opening, wherein the substrate comprises at least one GaN or GaN layer;
b. performing a first plasma etch step to anisotropically etch the at least one GaN or GaN alloy layer through the opening to produce a partially formed feature having one or more side walls and a bottom surface comprising a peripheral region, wherein the first plasma etch step uses an etch recipe comprising a chlorine-based etchant; and
c. performing a second plasma etch step to anisotropically etch the bottom surface of the partially formed feature through the opening while depositing a passivation material onto the walls, wherein the second plasma etch step uses an etch recipe comprising a chlorine-based etchant and a fluorocarbon-based passivation material precursor and wherein the deposition of the passivation material within the feature causes an attenuation in etching of the peripheral region thereby producing a fully formed feature having a bottom surface comprising a central region and an edge region, wherein the edge region is curved and the central region is deeper than the edge region of the bottom surface of the fully formed feature.

In this way, GaN etch features having curved bottom corners can be produced without the use of wet etch techniques. Instead, curved corners are produced using a dry etch solution which can be readily integrated into existing processes. Without wishing to be bound by any particular theory or conjecture, it is believed that the passivation material that deposits onto the side walls reduces the effective width of the partially formed feature and hence reduces the dimension of the opening leading to the bottom surface of the partially formed feature. This acts to protect the peripheral region from the distribution of species in the plasma during the second plasma etch step. Consequently, the amount of material removed from the peripheral region during the second plasma etch step is less than the amount of material removed from the central region. Controlling the reduction in dimension of the opening during the second plasma etch step allows the etch profile at the bottom of the feature to be controlled and formed into a desired shape. GaN etch profiles typically follow the mask angle with a low degree of process controllability. Hence, achieving a reduction in profile angle sufficient to produce curved corners via changes in process conditions alone is significant, surprising and non-trivial. The present method allows features to have curved edge regions, which can be rounded or otherwise smooth surfaces (i.e. gradual changes in slope). This can improve the dispersion of electric fields in the feature and can help to minimise field bunching. Consequently, the present method can help to produce features having a high breakdown voltage. Additionally, the method can help to avoid the formation of micro-trenches forming in the edge region of the bottom surface (e.g. the corners) of the feature.

The passivation material can be deposited at a deposition rate that increases during the second plasma etch step. The deposition rate of the passivation material can increase during the second plasma etch step at an increasing rate of change. The effective width of the partially formed feature can reduce at an increasing rate of change. Increasing the deposition rate of the passivation material during the second plasma etch step can help to produce a feature having rounded corners in the edge region of the bottom surface. It has been found that this approach can avoid discontinuities appearing in the curved etch profile, particularly in the region in which the edge region meets the central region. As a result, features having a generally flat-bottomed U-shape profile can be provided.

At least one process parameter can be varied during the second plasma etch step. The process parameter that is varied can be ramped at an increasing rate of change. The process parameter that is varied can be ramped at an exponentially increasing rate of change. Alternatively, the process parameter that is varied can be ramped at a constant rate of change. The term "ramping" can mean either systematically increasing or systematically decreasing a value. A number of ways in which a process parameter can be varied during the second plasma etch step will now be described.

The varying of the process parameter can comprise increasing a flow rate of the passivation material precursor. The flow rate (in sccm) of the passivation material precursor at the end of the second plasma etch step can be at least five times, ten times or fifty times higher than the flow rate (in sccm) of the passivation material precursor at the start of the second plasma etch step. The flow rate of the passivation material can be increased from about 0.5 to 5 sccm to about 80 to 120 sccm.

The etch recipe used in the second plasma etch step has an associated gas pressure. The varying of the process parameter can comprise increasing said gas pressure. The gas pressure at the end of the second plasma etch step can be at least five times, ten times or fifty times higher than the gas pressure at the start of the second plasma etch step. The gas pressure can be increased from about 1 to 5 mTorr to about 150 to 250 mTorr.

The second plasma etch step can use a plasma generated by a plasma generation device having an associated operating electrical power. The varying of the process parameter can comprise increasing said operating electrical power. The operating electrical power at the end of the second plasma etch step can be higher than the operating electrical power at the start of the second plasma etch step by an amount in the range of about 300-600 W. The operating electrical power at the start of the second plasma etch step can be a power in the range of about 150-250 or about 200 W. The operating electrical power at or towards the end of the second plasma etch step can be a power in the range of about 500-800 W, about 550-650 W, or about 600 W. The operating electrical power during the second plasma etch step can be the same or higher than the operating electrical power during the first plasma etch step. The operating electrical power during the first plasma etch step can be in the range of about 150-250 W, or about 200 W.

The etch recipe used in the second plasma etch step can comprise an inert gas having an associated flow rate. The varying of the process parameter can comprise decreasing the flow rate of the inert gas. The flow rate (in sccm) of the inert gas at the end of the second plasma etch step can be at least 20% or 30% lower than the flow rate (in sccm) of the passivation material precursor at the start of the second plasma etch step. The flow rate of the passivation material can be decreased from about 75 to 125 sccm to about 50 to 75 sccm.

The passivation material precursor can be one or more of C₄F₈, C₅F₈, C₄F₆ and CF₄. C₄F₈ is particularly effective.

The etch recipe used in the second plasma etch step can comprise the chlorine-based etchant, the fluorocarbon-based passivation material precursor and an inert gas. The chlorine-based etchant can be Cl₂ or BCl₃. The inert gas can be Argon.

The etch recipe used in the first plasma etch step can comprise the chlorine-based etchant and an inert gas. The chlorine-based etchant can be Cl₂ or BCl₃. The inert gas can be Argon. In principle, the first and second plasma etch streps can use different chlorine-based etchants. However, it is advantageous that the same chlorine-based etchant can be used for both etch steps.

The feature can be a trench. The feature can be a via.

The central region of the bottom surface of the fully formed feature can be substantially flat. The edge region can form a rounded corner between the central region of the bottom surface and a side wall of the fully formed feature.

Without wishing to be bound by any particular theory or conjecture, it is believed that the passivation material is an organic (carbon based) material which is likely to be polymeric.

The mask can be of any suitable type. The mask can be a photoresist mask. The mask can be a hard mask, such as a SiOz hard mask.

The steps (b) and (c) can be performed using an inductively coupled plasma (ICP) etch device.

The fully formed feature can have a depth in the range 1.0 to 3.0 microns. The fully formed feature can have a depth in the range 1.0 to 5.0 microns.

The first plasma etch step can be performed to produce the partially formed feature having a depth which is between 60 to 80% of the depth of the fully formed feature.

The method can further comprise: selectively removing the passivation material from the substrate after performing the second plasma etch step. Any suitable removal technique can be used, which can be a dry or wet etching technique.

The GaN or GaN alloy can be present as a single layer or as more than one layer, for example in a stack of layers. Different GaN or GaN alloy layers can be provided with different degrees of doping.

The substrate can comprise additional layers. For example, the substrate can comprise one or more dielectric layers. A dielectric layer can be located directly underneath the mask. The dielectric layer can be silicon dioxide. The substrate can comprise a support layer underneath a GaN or GaN alloy layer. The support layer can be formed of a material such as AIN that aids epitaxial growth of a GaN or GaN alloy.

According to a second aspect of the invention there is provided a substrate comprising at least one GaN or GaN alloy layer having a feature formed using the method according to the first aspect of the invention, wherein the feature comprises a bottom surface, the bottom surface comprising a central region and an edge region, wherein the edge region is curved and the central region is deeper than the edge region of the bottom surface of the fully formed feature.

The feature can comprise a side wall that is substantially perpendicular to the central region. The feature can have a bottom surface (or base) comprising rounded corners. The edge region of the bottom surface can comprise a curved surface. The edge region can provide a continuous change in slope from the central region to a substantially perpendicular sidewall of the feature.

The feature can be a trench. The feature can be a via.

According to a third aspect of the invention there is provided a plasma etch apparatus for plasma etching a substrate comprising at least one GaN or GaN alloy layer to form a feature using the method according to the first aspect of the invention, the apparatus comprising:
a chamber;
a substrate support disposed within the chamber for supporting a substrate thereon;
at least one gas inlet for introducing a gas or gas mixture into the chamber at a flow rate;
a plasma generation device for sustaining a plasma in the chamber;
a power supply for supplying a bias electrical signal having an associated bias power to the substrate support; and
a controller configured to switch from a first set of processing conditions to a second set of processing conditions, wherein the first set of processing conditions are configured to perform a first plasma etch step to anisotropically etch the at least one GaN or GaN alloy layer through the opening to produce a partially formed feature having one or more side walls and a bottom surface comprising a peripheral region, wherein the first plasma etch step uses an etch recipe comprising a chlorine-based etchant, and the second set of processing conditions are configured to perform a second plasma etch step to anisotropically etch the bottom surface of the partially formed feature through the opening while depositing a passivation material onto the walls, wherein the second plasma etch step uses an etch recipe comprising a chlorine-based etchant and a fluorocarbon-based passivation material precursor and wherein the deposition of the passivation material within the feature causes an attenuation in etching of the peripheral region thereby producing a fully formed feature having a bottom surface comprising a central region and an edge region, wherein the edge region is curved and the central region is deeper than the edge region of the bottom surface of the fully formed feature.

The plasma generation device can be an ICP etch device.

For the avoidance of doubt, whenever reference is made herein to 'comprising' or 'including' and like terms, the invention is also understood to include more limiting terms such as 'consisting' and 'consisting essentially'.

Whilst the invention has been described above, it extends to any inventive combination of the features set out above, or in the following description, drawings or claims. Any features disclosed in relation to one of the first, second and third aspects of the invention may be combined with any features disclosed in relation to another aspect of the invention as appropriate.

### Description of the Drawings

Embodiments of the invention will now be described, by way of example only, with reference to the accompanying drawings, in which:
Figure 1 is a cross-sectional semi-schematic view of stages in a GaN trench etching process, wherein (a) is prior to commencement of the etch process, (b) is after a first plasma etch step and (c) is at completion of the process including a second plasma etch step;
Figure 2 is a cross-sectional schematic view of a plasma etch apparatus suitable for performing the invention;
Figure 3 is a cross-sectional semi-schematic view of a substrate at various stages of the second plasma etch step; and
Figure 4 shows ramping of C₄F₈ flow rate as a function of time during the second plasma etch step in two process schemes.

### Detailed Description of the Disclosure

The invention provides a two-step plasma etch process for etching GaN or a GaN alloy to produce an etched feature having curved lower corners. The first plasma etch step is an anisotropic etch using a chlorine-based etchant. This etch step is a `bulk' or 'main' etch which etches the majority of the depth of the feature. The second plasma etch step also uses a chlorine-based etchant but also includes a fluorocarbon-based passivation material precursor which enables deposition of passivation material to take place onto the side walls of the feature as the second plasma etch step progresses. Without wishing to be bound by theory, it is believed that the deposition of passivation material acts to reduce the profile angle, which in turn causes attenuation of etching in the edge regions of the bottom surface of the feature.

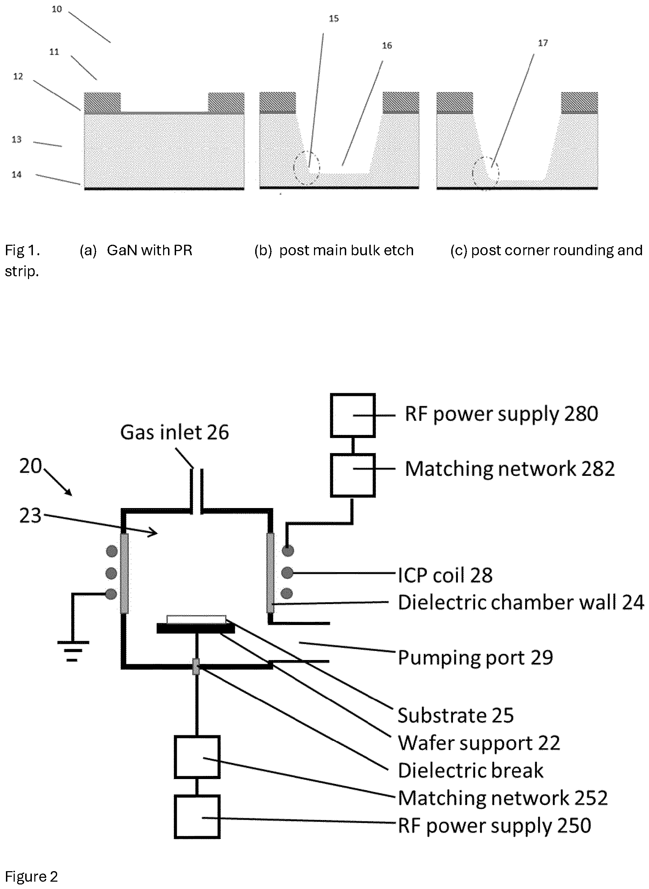

Figure 1 shows stages in a simplified process flow in which a substrate 10 undergoes etching. Figure 1 (a) shows the substrate prior to commencement of the etching process. The substrate 10 comprises a GaN device layer or layers 13, optionally with additional thin dielectric layers12 such as SiOz located on the GaN layer 13. A mask 11 is formed on an upper surface of the substrate 10. Instead of a single layer of GaN, a number of layers of GaN may be present. The substrate 10 can further comprise one or more additional, base layers 14, such as an AIN layer, located beneath the epitaxial layers of GaN. The additional layer 14 aids the epitaxial growth process. The first, main, anisotropic plasma etch step of the GaN layer 13 is performed to etch a partially formed trench as shown in Figure 1 (b). The first plasma etch step can be preceded by one or more initial etch steps to open the layers 12 if present in the substrate 10. The base of the partially formed trench comprises edge regions 15 and a central region 16. The central region 16 is preferably flat as can be seen in Figure 1 (b). At this stage in the process, the lower corner of the edge region 15 of the trench, i.e. the location where the trench side wall meets the base of the trench, is relatively sharp. This type of feature is undesirable as it results in current leakage under certain operating conditions. Advantageously, the second plasma etch step produces rounded or otherwise curved corners while simultaneously slightly extending the depth of the feature. Figure 1 (c) shows the fully formed trench following the second plasma etch step and a plasma strip process to remove the passivation material. The rounded corners 17 of the edge region can be seen. When a flat based etch is used as a gate etch in a vertical or semi-vertical GaN MOSFET device, the off-state leakage is notably improved. With a rounded corner, reductions to on-state leakage can be achieved, with a resulting increase in device breakdown voltage.

Figure 2 shows a schematic representation of a plasma etch apparatus 20 suitable for performing the present invention. Plasma etching of the substrate is typically performed using a plasma etch apparatus. The plasma etch apparatus can be an inductively coupled plasma (ICP) apparatus such as the Omega Synapse^{™} tool available from SPTS Technologies Limited of Newport, UK. However, etching can also be performed using other dry etch systems, such as helicon, RIE or microwave type apparatus. The generation of a plasma within such plasma etch apparatus is well-known in the art and will not be described here other than where necessary for an understanding of the present invention.

A plasma etch apparatus 20 shown in Figure 2 is an ICP apparatus which typically comprises a substrate support (or platen) 22 disposed within a chamber 23 for supporting the substrate 25. A bias power can be supplied to the substrate by a RF power supply 250 via an impedance matching network 252. The chamber can comprise a chamber wall having a dielectric part 24. Process gases can be introduced into the chamber via one or more gas inlets 26. A plasma generating device 28, such as an inductive coil, can be used to generate and sustain a plasma within the chamber 23 as is known in the art (e.g. using a RF power supply 280 and impedance matching network 282). The gases can be removed from the chamber 23 via a pumping port 29.

The second plasma etch step will now be described in more detail. Once the etch front of the first plasma etch step has progressed to a desired endpoint, the second plasma etch step is commenced. The desired endpoint might be at any suitable depth. Often a depth of approximately 70% the depth of the final feature is appropriate, but the exact endpoint depth can be changed to suit the exact morphology of the corners resulting from the process. In the second plasma etch step, a passivation material precursor gas such as C₄F₈ provides excellent results despite being used in combination with a chlorine-based etchant. When C₄F₈ is added at an appropriate constant flow level, a change in profile has been observed due to deposition of passivation on the side walls of the feature. The profile changes towards a more tapered, positive angle as the second plasma etch step progresses further, deviating from the preceding profile angle. GaN etch profiles typically follow the angle of the mask with a low degree of process controllability. Hence, achieving such a reduction in profile angle typically about 80°-60°) via process changes alone is significant and non-trivial.

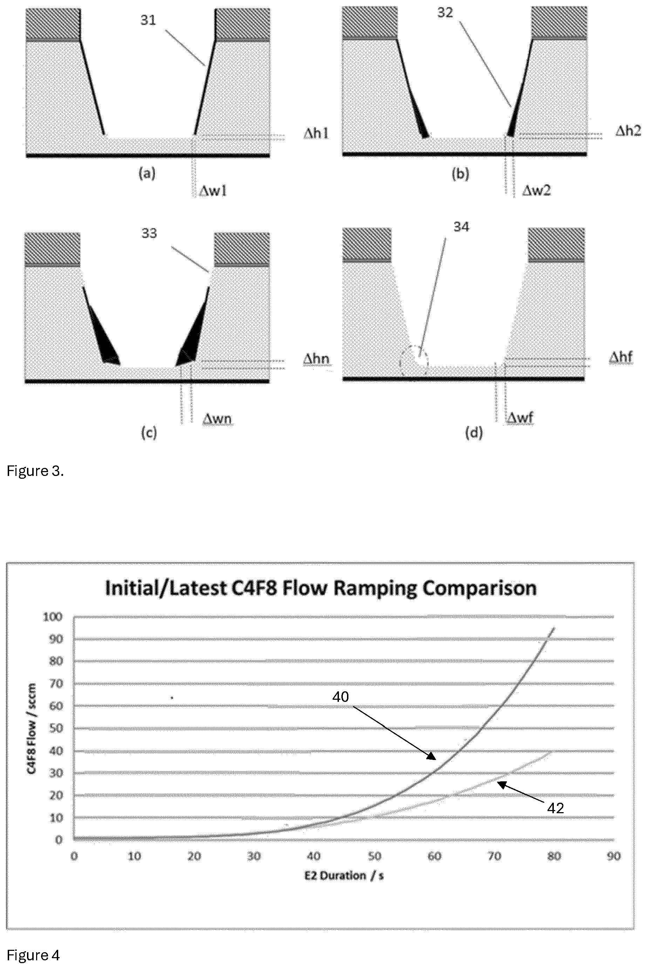

It has been found that ramping of one or more process parameters improves the rounding of the feature corners. Figure 3 is a semi-schematic representation of stages in an idealised process. Figure 3 (a) shows the early stages of a second plasma etch step performed at relatively overall low pressures, C₄F₈ gas flows and source power to the plasma generating device. Under these conditions, a relatively thin conformal layer of passivation material 31 is deposited on the side walls of the etched feature. The feature is preferentially etched on the exposed bottom surface, resulting in slight reduction in the width of the trench Δw1 and the depth Δh1. Figures 3 (b) and 3 (c) show further stages in the second plasma etch step in which overall pressure, C₄F₈ flow and source power are progressively increased. Higher passivation deposition rates are achieved while still maintaining a stable plasma. Without wishing to be bound by theory, it is believed that the higher pressures result in greater scattering and an increase in the angular distribution of ions reaching the substrate. This in turn is believed to increase the effective etch rate at regions such as 32 and 33 closer to the top of the feature, while further etching the exposed surface of the base of the trench. Reducing the Ar flow rate is believed to decrease the ionic nature of the etch and introduce a more chemical balance in favour of depositing passivation material. As a result, the width of the feature is progressively and continuously reduced from Δw1 to Δw2 to Δwn while the depth increases from Δh1 to Δh2 to Δhn, where n is the number of discrete steps performed until the target value is reached. After the second plasma etch step has finished, a passivation strip step is performed using a known technique, which can a wet or dry technique. This results in the fully formed feature having rounded corners 34 as shown in in Figure 3 (d). Through judicious choice of process parameters, the rate of change of Δw and Δh can be controlled to achieve the required corner profile.

A linear increase of C₄F₈ flow rate during the second plasma etch step is believed to facilitate a progressive reduction in profile angle as a function of time, resulting in an edge region profile that has a curvature. The morphology of the curvature may not necessarily be circular, and this curved profile may have a changing radius as a function of feature depth. A more constant radius can be produced by introducing a non-linear ramp. An exponential ramp profile has been found to provide excellent results. Figure 4 shows two exponential ramping process schemes 40, 42 for ramping the C₄F₈ flow rate such that the initial stages of the second plasma step result in minimal changes to the C₄F₈ flow rate, whilst the end of this step delivers significant flows of C₄F₈, delivering partially rounded corners. The process scheme 40 is particularly effective. The exponential process schemes are also advantageous in preventing sudden changes in profile where a discontinuity is present. Other non-linear ramping process schemes might be contemplated, such as logarithmic schemes. It has been found that substantial increases in C₄F₈ flow rate are necessary to deliver favourably curved edge region profiles. Increases from a low flow rate of less than 5 sccm and typically 1 sccm to at least 40 sccm have been used, although other flow rates regimes may be applicable to other etching apparatus. Although Figure 4 exemplifies the ramping of C₄F₈ flow rate, other process parameters can be ramped as well as or instead of C₄F₈ flow rate. In fact, it has been found that significant increases in pressure, plasma density (by increasing the source power) and C₄F₈ flow rate can reduce or even eliminate the discontinuities and introduce a constant radius of curvature to achieve fully rounded corners or otherwise provide a gradual profile change in the edge region. It has been found that it is very effective to progressively increase the deposition rate of passivation material in an exponential manner as the etch progresses to the point at which the curvature of the bottom of the feature becomes flat. Exemplar processes and parameters which have achieved this result are described below.

### Example

Experimental work was carried out on epitaxial GaN layers on 200mm silicon wafers with a photoresist mask (3µm) and 2-4µm CDs. Trench depth was nominally about 1.5-2µm. An Omega Synapse^{™} ICP etch tool (SPTS Technologies Limited of Newport, UK) was used to perform the first and second plasma etch steps. A flat based trench as generally show in in Figure 1 (b) was achieved using a first plasma etch step with the conditions shown in Table 1.

**Table 1. First plasma etch step process parameters.**

| **Parameter** | **Value** |
|---|---|
| Chamber Pressure (mTorr) | 3 |
| Source Power (W) | 200 |
| Platen Power (W) | 450 |
| ESC Temperature (°C) | 20 |
| Chlorine (sccm) | 50 |
| Argon (sccm) | 100 |

A second plasma etch step with the conditions shown in Table 2 was performed followed by a passivation material strip step. Chamber pressure, source power and C₄F₈ flow rate were increased and Ar flow rate was decreased using an exponential ramping scheme. The resulting trenches were found to have excellent profiles with flat central regions and rounded edge regions with no discontinuities between the regions.

**Table 2. Process conditions for main etch and corner rounding step.**

| **Parameter** | **Main Etch** | **Rounded Step** |
|---|---|---|
| Duration (s) | 210 | 80 |
| Chamber Pressure (mTorr) | 3 | 3→220 |
| Source Power (W) | 200 | 200→600 |
| Platen Power (W) | 450 | 450 |
| Ar (sccm) | 100 | 100→60 |
| Cl₂ (sccm) | 50 | 50 |
| C₄F₈ (sccm) | -- | 1→95 |

The skilled reader will appreciate that many variations to the processes exemplified above are possible. For example, other chlorine-based etchants, such as BCl₃, might be used. Other passivation material precursors can be used, such as C₅F₈, C₄F₆ or CF₄. The principles described above for varying process conditions during the second plasma etch step can be readily adapted by the skilled reader to suit the exact processing environment and the desired profile of the corners of the feature. In addition to etching through photoresist masks, other masks such as hard masks might be used.

## Claims

1. A method of plasma etching a substrate comprising at least one GaN or GaN alloy layer to form a feature, the method comprising the steps of:
a. providing a substrate with a mask formed thereon, the mask having an opening, wherein the substrate comprises at least one GaN or GaN layer;
b. performing a first plasma etch step to anisotropically etch the at least one GaN or GaN alloy layer through the opening to produce a partially formed feature having one or more side walls and a bottom surface comprising a peripheral region, wherein the first plasma etch step uses an etch recipe comprising a chlorine-based etchant; and
c. performing a second plasma etch step to anisotropically etch the bottom surface of the partially formed feature through the opening while depositing a passivation material onto the walls, wherein the second plasma etch step uses an etch recipe comprising a chlorine-based etchant and a fluorocarbon-based passivation material precursor and wherein the deposition of the passivation material within the feature causes an attenuation in etching of the peripheral region thereby producing a fully formed feature having a bottom surface comprising a central region and an edge region, wherein the edge region is curved and the central region is deeper than the edge region of the bottom surface of the fully formed feature.

2. A method according to claim 1, wherein the passivation material is deposited at a deposition rate that increases during the second plasma etch step.

3. A method according to claim 1 or 2, wherein at least one process parameter is varied during the second plasma etch step.

4. A method according to claim 3, wherein the process parameter that is varied is ramped at an increasing rate of change and optionally the process parameter that is varied is ramped at an exponentially increasing rate of change.

5. A method according to claims 3 or claim 4, wherein the varying of the process parameter comprises increasing a flow rate of the passivation material precursor.

6. A method according to any one of claims 3 to 5 wherein the etch recipe used in the second plasma etch step has an associated gas pressure and the varying of the process parameter comprises increasing said gas pressure.

7. A method according to any one of claims 3 to 6, wherein the second plasma etch step uses a plasma generated by a plasma generation device having an associated operating electrical power and the varying of the process parameter comprises increasing said operating electrical power.

8. A method according to any one of claims 3 to 7, wherein the etch recipe used in the second plasma etch step comprises an inert gas having an associated flow rate and the varying of the process parameter comprises decreasing the flow rate of the inert gas.

9. A method according to any previous claim, wherein the passivation material precursor is one or more of C₄F₈, C₅F₈, C₄F₆ and CF₄.

10. A method according to any previous claim, wherein the etch recipe used in the second plasma etch step comprises the chlorine-based etchant, the fluorocarbon-based passivation material precursor and an inert gas, and optionally the chlorine-based etchant is Cl₂ and the inert gas is Argon.

11. A method according to any previous claim, wherein the etch recipe used in the first plasma etch step comprises the chlorine-based etchant and an inert gas, and optionally the chlorine-based etchant is Cl₂ and the inert gas is Argon.

12. A method according to any previous claim, wherein the feature is a trench and/or wherein the central region of the bottom surface of the fully formed feature is substantially flat and, optionally, the edge region forms a rounded corner between the central region of the bottom surface and a sidewall of the fully formed feature.

13. A method according to any previous claim, wherein the mask is a photoresist mask or a hard mask; and/or wherein steps (b) and (c) are performed using an inductively coupled plasma (ICP) etch apparatus.

14. A substrate comprising at least one GaN or GaN alloy layer having a feature formed using the method according to claim 1, wherein the feature comprises a bottom surface, the bottom surface comprising a central region and an edge region, wherein the edge region is curved and the central region is deeper than the edge region of the bottom surface of the fully formed feature.

15. A plasma etch apparatus for plasma etching a substrate comprising at least one GaN or GaN alloy layer to form a feature using the method according to claim 1, the apparatus comprising:
a chamber;
a substrate support disposed within the chamber for supporting a substrate thereon;
at least one gas inlet for introducing a gas or gas mixture into the chamber at a flow rate;
a plasma generation device for sustaining a plasma in the chamber;
a power supply for supplying a bias electrical signal having an associated bias power to the substrate support; and
a controller configured to switch from a first set of processing conditions to a second set of processing conditions, wherein the first set of processing conditions are configured to perform a first plasma etch step to anisotropically etch the at least one GaN or GaN alloy layer through the opening to produce a partially formed feature having one or more side walls and a bottom surface comprising a peripheral region, wherein the first plasma etch step uses an etch recipe comprising a chlorine-based etchant, and the second set of processing conditions are configured to perform a second plasma etch step to anisotropically etch the bottom surface of the partially formed feature through the opening while depositing a passivation material onto the walls, wherein the second plasma etch step uses an etch recipe comprising a chlorine-based etchant and a fluorocarbon-based passivation material precursor and wherein the deposition of the passivation material within the feature causes an attenuation in etching of the peripheral region thereby producing a fully formed feature having a bottom surface comprising a central region and an edge region, wherein the edge region is curved and the central region is deeper than the edge region of the bottom surface of the fully formed feature.
